# EUROPÄISCHE PATENTSCHRIFT

(11) **EP 2 202 884 B1**
(45) Veröffentlichungstag und Bekanntmachung des Hinweises auf die Patenterteilung: **15.09.2010**
(21) Anmeldenummer: 08172700.0
(22) Anmeldetag: 23.12.2008
(51) Int. Cl.: H03K 17/06, H03K 17/16, H02M 1/32, H03K 17/20, H02H 1/06

(54) **Elektrische Schaltung mit selbstleitendem Halbleiterschalter**
Electric circuit with self-conducting semiconductor switch
Circuit électrique avec commutateur semi-conducteur normalement conducteur

(43) Veröffentlichungstag der Anmeldung: 30.06.2010
(73) Patentinhaber: SMA Solar Technology AG, 34266 Niestetal (DE)
(72) Erfinder: Friebe, Jens, 37176 Nörten-Hardenberg (DE); Prior, Oliver, 34431 Marsberg (DE); Greizer, Frank, 34260 Kaufungen (DE); Victor, Matthias, 34266 Niestetal (DE); Bremicker, Sven, 36211 Alheim (DE)
(74) Vertreter: Rehberg Hüppe + Partner

(56) Entgegenhaltungen:
- EP-A1- 1 768 251
- WO-A2-02/50897
- WO-A2-02/103886
- US-A1- 2008 174 184

## Beschreibung

### TECHNISCHES GEBIET DER ERFINDUNG

Die Erfindung bezieht sich auf einen elektrische Schaltung mit den Merkmalen des Oberbegriffs des unabhängigen Patentanspruchs 1, die auch als Wechselrichter zu bezeichnen ist.

Insbesondere bezieht sich die vorliegende Erfindung auf Wechselrichter zur Einspeisung von elektrischer Energie von einer Gleichspannungsquelle in ein Wechselspannungsnetz. Noch spezieller kann die Gleichspannungsquelle dabei eine Photovoltaikanlage sein.

Ein Wechselrichter, wie er insbesondere Gegenstand der vorliegenden Erfindung ist, kann aber auch zu anderen Zwecken verwendet werden, wobei die Frequenz der Ausgangswechselspannung, auf die der Wechselrichter richtet, konstant oder variabel sein kann, um beispielsweise einen Wechselspannungsmotor anzusteuern.

Weiterhin kann ein erfindungsgemäßer Wechselrichter für einphasigen Wechselstrom oder mehrphasigen, insbesondere dreiphasigen Drehstrom vorgesehen sein, selbst wenn im Folgenden nur ein einphasiger Wechselrichter beschrieben ist. Auch eine Kombination des Wechselrichters mit weiteren elektrischen oder elektronischen Einheiten, wie beispielsweise einem vorgeschalteten Hochsetzsteller oder dergleichen ist möglich. Die vorliegende Erfindung betrifft dann den Aufbau des Wechselrichters als solchen.

### STAND DER TECHNIK

Ein Wechselrichter mit einer H-förmigen Wechselrichterbrücke zwischen zwei Eingangsleitungen, wobei die Wechselrichterbrücke Halbleiterschalter aufweist, und mit einer die Halbleiterschalter im Betrieb des Wechselrichters taktenden Steuerung ist z.B. aus der DE 10 2004 030 912 B3 bekannt. Hier sind die Halbleiterschalter als MOSFET-Halbleiterbauelemente, d. h. als Metall-Oxid-Halbleiter-Feldeffekttransistor ausgebildet. Derartige Feldeffekttransistoren sind selbstsperrend, d. h. ohne Ansteuerung ihres Steueranschlusses leiten sie nicht. Dies ist insoweit vorteilhaft, als dass die gesamte Wechselrichterbrücke ohne Ansteuerung der Steueranschlüsse der Halbleiterschalter nicht leitet und damit einen Kurzschluss zwischen den Eingangsleitungen und auch eines ausgangsseitigen Wechselspannungsnetzes verhindert. So kann sich über die Wechselrichterbrücke hinweg eine Eingangsspannung aufbauen, die als Versorgungsspannung für die Steuerung verwendbar ist. Dieser Fall tritt beispielsweise bei Verwendung des bekannten Wechselrichters zur Einspeisung elektrischer Energie von einer Photovoltaikanlage in ein Wechselstromnetz am Morgen auf, wenn die Photovoltaikanlage beginnt, Strom zu erzeugen. Speziell ist bei dem aus der DE 10 2004 030 912 B3 bekannten Wechselrichter in einer der Eingangsleitungen ein zusätzlicher, als MOSFET-Halbleiterbauelement ausgebildeter Halbleiterschalter vorgesehen, der ebenso wie die in den an die andere Eingangsleitung angeschlossenen Zweigen der Wechselrichterbrücke vorgesehenen Halbleiterschalter mit einer höheren Frequenz getaktet wird, während die beiden anderen Halbleiterschalter der Wechselrichterbrücke mit einer niedrigeren Frequenz getaktet werden. Diese niedrigere Frequenz entspricht dabei der Frequenz, auf die der Wechselrichter richtet, während die höhere Frequenz genutzt wird, um den erzeugten Wechselstrom mittels Pulsbreitenmodulation zu formen. Alle als MOSFET-Halbleiterbauelemente ausgebildeten Halbleiterschalter sind bei dem bekannten Wechselrichter mit antiparallelen Dioden versehen.

Über einen Rekord für den Wirkungsgrad eines Wechselrichters wird in einer Presseinformation Nr. 02/08 des Fraunhofer-Instituts für Solare Energiesysteme ISE vom 15. Januar 2008 (http://www.ise.fhg.de/presse-und-medien/presseinformationenpdf/0208_ISE_PI_d_Rekord_Wechselrichterwirkungsgrad.pdf) berichtet. Bei dem Wechselrichter, der Gegenstand der Presseinformation ist, wurden MOSFETs auf Basis des Halbleiters Siliziumkarbid (SiC) verwendet. Von SiC-Halbleiterbauelementen ist nicht nur bekannt, dass sie sehr gute Eigenschaften wie niedrige Durchlass- und Schaltverluste aufweisen, sondern auch, dass sie jenseits des Temperaturbereichs, in dem Siliziumhalbleiterbauelemente funktionsfähig sind, d. h. bis zu 600°C, einsetzbar sind. Bei MOSFETs auf der Basis von SiC handelt es sich jedoch um nicht allgemein verfügbare Halbleiterbauelemente, die daher zumindest derzeit noch keinen umfangreichen Einsatz bei Wechselrichtern finden können und die in der derzeitigen Ausführung wiederum eine Temperaturbegrenzung aufweisen.

Zu vertretbaren Bedingungen verfügbar sind hingegen Sperrschicht-Feldeffekttransistoren (JFETs) auf SiC-Basis. JFETs sind jedoch im Allgemeinen selbstleitende Halbleiterbauelemente, d. h. sie leiten, ohne dass eine Spannung an ihrem Steueranschluss anliegt. Um diesen Nachteil zu kompensieren, ist eine sogenannte Kaskoden-Schaltung als elektrische Schaltung mit den Merkmalen des Oberbegriffs des unabhängigen Patentanspruchs 1 bekannt, bei der ein JFET mit einem MOSFET kombiniert ist und bei der eine Eingangsspannung auf den Steueranschluss des JFETs und über den MOSFET zur Source des JFETs verzweigt ist. Mittels Ansteuerung des Steueranschlusses des MOSFETs wird der JFET bei der Kaskodenschaltung indirekt geschaltet. Dabei ist von Vorteil, dass das Sperrvermögen des SiC-JFET genutzt wird und der MOSFET nur eine geringe Sperrspannungsfestigkeit aufweisen muss. Allerdings fließt der Leistungsstrom auch über den MOSFET, welcher das Schaltverhalten der gesamten Kaskode maßgeblich beeinflusst, so dass eine Kaskode mit allen weiteren Nachteilen eines MOSFETs gegenüber einem JFET belastet ist.

Bei einem bekannten Wechselrichter mit einer Wechselrichterbrücke auf Basis selbstleitender Halbleiterschalter sind die selbstleitenden Halbleiterschalter jeweils in einer Kaskodenschaltung vorgesehen. Wie voranstehend erläutert wurde, können so die Vorteile eines JFET nur sehr begrenzt ausgenutzt werden, insbesondere die Vorteile eines JFET auf SiC-Basis, da dessen hohe Temperaturbeständigkeit angesichts der geringeren Temperaturbeständigkeit des MOSFETs in derselben Kaskode unbedeutend ist. Zudem ist die Anzahl der Halbleiterschalter aufgrund eines JFETs und eines MOSFETs für jede schaltende Einheit doppelt so groß wie eigentlich nötig.

Aus der US 2008/0174184 A1 ist eine Vorrichtung zum Ansteuern eines selbstleitenden elektronischen Leistungsschalters z. B. in einer Wechselrichterbrücke bekannt. Dabei sind die Merkmale des Oberbegriffs des unabhängigen Patentanspruchs 1 verwirklicht. Die Gleichspannungsquelle, die bei Ausfall der Steuerung das Sperrpotential an die Steueranschlüsse der selbstleitenden Halbleiterschalter anlegt, umfasst als Speicher für elektrische Ladung je Schalter einen Kondensator, der über eine Ladediode aus der Versorgungsspannung für die Steuerung des Schalters aufgeladen wird und aufgrund der Diode seine Ladung auch bei Zusammenbrechen der Versorgungsspannung hält. Das Sperrpotential steht daher erst dann zur Verfügung, wenn die Versorgungsspannung der Steuerung einmal vorhanden war.

Aus der EP 1 768 251 A1 ist eine Schutzschaltung für einen Synchronmotor mit Permanentmagneten bekannt, bei der selbstsperrende Schalter einer Wechselrichterbrücke zur Ansteuerung des Motors auch dann in definierte Schaltzustände versetzt werden, wenn eine Hauptenergieversorgung der Steuerung ausfällt. Zu diesem Zweck ist neben der Hauptenergieversorgung eine Ersatzenergieversorgung für die Steuerung vorgesehen. Sowohl die Hauptenergieversorgung als auch die Ersatzenergieversorgung werden aus der Eingangsspannung der Wechselrichterbrücke gespeist.

Aus der WO 02/50897 A2 ist eine leistungselektronische Schaltung in Form einer Wechselrichterbrücke mit selbstleitenden Halbleiterschaltern bekannt. Eine die Halbleiterschalter taktende Steuerung wird aus einer Eingangsspannung der Wechselrichterbrücke mit elektrischer Energie gespeist. Dazu sind eine Diode und ein Kondensator zwischen die Eingangsleitungen in Reihe geschaltet. Der Kondensator behält seine Ladung aufgrund der Diode auch dann, wenn die Spannung zwischen den Eingangsleitungen zusammenbricht. Auf diese Weise bleibt die Energieversorgung der Steuerung, die auf der Spannung über diesem Kondensator basiert, auch noch für gewisse Zeit nach einem solchen Zusammenbruch erhalten.

### AUFGABE DER ERFINDUNG

Der Erfindung liegt die Aufgabe zugrunde, eine elektrische Schaltung mit den Merkmalen des Oberbegriffs des unabhängigen Patentanspruchs 1 aufzuzeigen, bei der ein Kurzschluss zwischen den Eingangsleitungen der Schaltung in jedem Betriebszustand sicher vermieden wird, auch wenn erst eine geringe Spannung über der Schaltung anliegt.

### LÖSUNG

Die Aufgabe der Erfindung wird durch eine elektrische Schaltung mit den Merkmalen des unabhängigen Patentanspruchs 1 gelöst. Die abhängigen Patentansprüche 2 bis 6 definieren bevorzugte Ausführungsformen der neuen Schaltung. Der unabhängige Patentanspruch 7 ist auf eine bevorzugte Verwendung der neuen Schaltung als Wechselrichter gerichtet.

### BESCHREIBUNG DER ERFINDUNG

Die neue elektrische Schaltung mit dem mindestens einen selbstleitenden Halbleiterschalter ist ihrerseits zwischen den Eingangsleitungen selbstleitend. Das heißt, die selbstleitenden Halbleiterschalter sind nicht nach Art einer Kaskode mit einem selbstsperrenden Halbleiterschalter in Reihe geschaltet und über einen solchen selbstsperrenden Halbleiterschalter indirekt getaktet. Vielmehr steuert die Steuerung der neuen Schaltung die Steueranschlüsse der selbstleitenden Halbleiterschalter direkt mit Steuerspannungen an. Um dabei einen Kurzschluss zwischen den Eingangsleitungen zu verhindern, wenn die Steuerspannungen ausfallen, ist eine Gleichspannungsquelle vorgesehen, die bei Ausfall der Steuerung ein Sperrpotential an den Steueranschluss des selbstleitenden Halbleiterschalters anlegt. Diese Gleichspannungsquelle kann einfach gehalten sein, da für die Anlegung des Sperrpotentials an einen selbstleitenden Halbleiterschalter nur geringe Ladungsmengen erforderlich sind. Mit einer einfachen zusätzlichen Gleichspannungsquelle, d. h. mit geringem Aufwand kann der Nachteil selbstleitender Halbleiterschalter kompensiert werden. Dabei ist nicht je selbstleitendem Halbleiterschalter eine eigene Gleichspannungsquelle erforderlich. Vielmehr kann eine solche zusätzliche Gleichspannungsquelle problemlos eine Vielzahl von Halbleiterschaltern mit dem Sperrpotential bei Ausfall der Steuerung bedienen.

Besonderer Vorteil der neuen elektrischen Schaltung ist, dass die zusätzliche Gleichspannungsquelle kein in Reihe mit den Halbleiterschaltern der Wechselrichterbrücke zwischen die Eingangsleitungen geschaltetes Bauteil erfordert, um die Nachteile der selbstleitenden Halbleiterschalter zu kompensieren, d. h., dass der durch die Schaltung fließende Strom keine zusätzlichen Verluste hervorruft.

Auch parallel zu der Wechselrichterbrücke zwischen die beiden Eingangsleitungen ist bei der neuen Schaltung typischerweise kein Bauteil geschaltet, über das während des Betriebs der Schaltung andauernd Strom fließt, der ebenfalls eine Verlustleistung verursachen würde.

Die Gleichspannungsquelle der neuen Schaltung baut auf einem Speicher für elektrische Ladung auf. Dieser Speicher weist einen sich über die Schaltung aufladender Akkumulator oder Kondensator auf. Für das Aufladen des Akkumulators oder Kondensators wird zwar elektrische Leistung verbraucht, dies aber nicht andauernd und bei sachgerechter Dimensionierung des Speichers für elektrische Ladung nur in geringem Umfang.

Konkret weist die Gleichspannungsquelle eine zwischen die Eingangsleitungen mit einem weiteren selbstleitenden Halbleiterschalter in Reihe geschalteten Ladeschaltung für den Speicher für elektrische Ladung, z. B. einen phtovoltaischen MOSFET-Treiber, wie er von der Firma Panasonic unter der Bezeichnung Solardrive angeboten wird, auf. Die Ladeschaltung lädt bei fließendem Strom den Speicher für elektrische Ladung auf, wobei die als Sperrpotential dienende Spannung des Speichers für elektrische Ladung auch an dem Steueranschluss des weiteren selbstleitenden Halbleiterschalters anliegt. Der Strom durch die Ladeschaltung wird dementsprechend dann gesperrt, wenn der Speicher für elektrische Ladung aufgeladen ist. D. h., durch die Ladeschaltung fließt nur eine geringe Menge an Strom. Zudem fließt dieser Strom bei geeignetem Aufbau der Ladeschaltung bereits dann, wenn erst eine geringe Spannung über der Schaltung anliegt. Vor höheren Spannungen wird die Ladeschaltung durch den mit ihm in Reihe geschalteten selbstleitenden Halbleiterschalter geschützt, der bei aufgeladenem Speicher für elektrische Ladung gesperrt ist.

Um die Gleichspannungsquelle, die die Sperrpotentiale an die selbstleitenden Halbleiterschalter der neuen Schaltung anlegt, von den leitenden Halbleiterschaltern zu trennen, wenn sie nicht benötigt wird, so dass einerseits die Steuerung beim Ansteuern der Halbleiterschalter nicht gestört wird und andererseits die Gleichspannungsquelle nicht unnötig belastet wird, kann zwischen der Gleichspannungsquelle und den Steueranschlüssen der selbstleitenden Halbleiteranschlüsse ein ansteuerbares Schaltelement angeordnet sein, dessen Steueranschluss die Steuerung im Betrieb der Schaltung mit einer Steuerspannung ansteuert, um es zu sperren. Dabei reicht ein solches Schaltelement für mehrere selbstleitende Halbleiterschalter aus; die gemeinsam von der Gleichspannungsquelle angesteuerten Steueranschlüsse mehrerer selbstleitender Halbleiterschalter sind aber durch Sperrdioden voneinander zu entkoppeln.

Das ansteuerbare Schaltelement zwischen der Gleichspannungsquelle und dem Steueranschluss ist vorzugsweise seinerseits ein selbstleitender Halbleiterschalter. D. h., das Schaltelement ist bei Ausfall der Steuerung leitend, so dass das Sperrpotential von der erfindungsgemäßen zusätzlichen Gleichspannungsquelle zu den Steueranschlüssen der zwischen die Eingangsleitungen geschalteten selbstleitenden Halbleiterschalter der neuen Schaltung genau dann gelangt und diese sperrt, wenn dies erforderlich ist.

Typischerweise liegt bei der neuen Schaltung zwischen den Eingangsleitungen eine Gleichspannung als Eingangsspannung an. Zumindest ist die Eingangsspannung von fester Polarität.

Bei der Wechselrichterbrücke muss die Gleichspannungsquelle bei Ausfall der Steuerung nicht an jeden der selbstleitenden Halbleiterschalter ein Sperrpotential anlegen, um einen Kurzschluss zwischen den Eingangsleitungen zu verhindern. Vielmehr kann hierzu eine Teilmenge der Halbleiterschalter der Wechselrichterbrücke ausgewählt werden. Eine derartige Auswahl wären beispielsweise je ein selbstleitender Halbleiterschalter je Zweig der Wechselrichterbrücke, wobei diese Halbleiterschalter alle in von derselben Eingangsleitung abgehenden Leitungen der Wechselrichterbrücke angeordnet sind. Um im Falle der Ausbildung der neuen Schaltung als Wechselrichter bei Ausfall der Steuerung auch einen Kurzschluss zwischen den Polen eines Wechselspannungsabgriffpunkts der Wechselrichterbrücke zu vermeiden, müssen aber noch weitere selbstleitende Halbleiterschalter mit Hilfe von Sperrpotentialen über die Gleichspannungsquelle gesperrt werden.

Wenn an diesem Wechselspannungsabgriffspunkt der Wechselrichterbrücke im Betrieb der neuen Schaltung immer eine Wechselspannung anliegt, kann auch diese Wechselspannung genutzt werden, um die erfindungsgemäße Gleichspannungsquelle zur Bereitstellung der Sperrpotentiale zu speisen. Dabei wird vorzugsweise nicht nur die Wechselspannung gleichgerichtet, sondern es kann auch ein Speicher für elektrische Ladung aufgeladen werden, um die Funktion der Gleichspannungsquelle selbst bei Ausfall der Wechselspannung sicherzustellen.

Ganz allgemein kann also nicht nur eine zwischen den Eingangsleitungen der neuen Schaltung vorliegende externe Spannung, sondern auch eine an Ihren Ausgangsleitungen anliegende externe Spannung für die Gleichspannungsquelle genutzt werden. Dabei versteht sich, dass die Gleichspannungsquelle der neuen Vorrichtung zur Bereitstellung der Sperrpotentiale auch aus verschiedenen externen Gleich- und/oder Wechselspannungen gespeist werden.

Die selbstleitenden Halbleiterschalter der neuen Schaltung können vorzugsweise auf SiC-Basis ausgebildet sein. Von ihrem grundsätzlichen Aufbau kann es sich um Feldeffekttransistoren handeln. Vorzugsweise sind die Feldeffekttransistoren sogenannte JFETs.

Wie bei Wechselrichtern üblich, kann auch bei der neuen Schaltung, die eine Wechselrichterbrücke aufweist, zwischen die Eingangsleitungen ein Pufferkondensator geschaltet sein.

Bei Ausbildung der neuen Schaltung als Wechselrichter kann in den Querzweig der Wechselrichterbrücke mindestens eine Induktivität geschaltet sein. Eine solche Induktivität kann auch auf beiden Seiten des dort vorgesehenen Wechselspannungsabgriffpunkts angeordnet sein. Hierbei handelt es sich um aus der DE 10 2004 030 912 B3 bekannte Maßnahme.

Ein gemäß der vorliegenden Erfindung ausgebildeter Wechselrichter ist besonders zur Einspeisung von elektrischer Energie von einer Gleichspannungsquelle in ein Wechselspannungsnetz geeignet. Bei der Gleichspannungsquelle kann es sich um eine Batterie, eine Brennstoffzelle, einen Brennstoffzellenstapel oder dergleichen handeln. Ganz besonders bevorzugt ist die Gleichspannungsquelle eine Photovoltaikanlage. Dabei ermöglicht es der Aufbau des neuen Wechselrichters trotz der bei einer Photovoltaikanlage über Nacht einbrechenden Eingangsspannung, die Steuerung des Wechselrichters aus dieser Eingangsspannung zu versorgen. Trotz der zwischen den Eingangsleitungen selbstleitenden Wechselrichterbrücke fließt zwischen den Eingangsleitungen kein Kurzschlussstrom, der einen Aufbau einer für die Versorgung der Steuerung ausreichenden Spannung zwischen den Eingangsleitungen verhindern würde.

Wie bereits in der Einleitung der vorliegenden Beschreibung angesprochen wurde, kann eine erfindungsgemäße Schaltung und kann damit auch ein erfindungsgemäßer Wechselrichter in unterschiedlichsten Umgebungen implementiert und dabei in verschiedenste größere Schaltungen integriert werden, wie Sie dem Fachmann grundsätzlich bekannt sind. Hierzu zählen unter anderem die Gleichrichtertopologien die unter den Stichworten H4, H5, Heric, 3-Level, 5-Level und Gonzales bekannt sind.

Vorteilhafte Weiterbildungen der Erfindung ergeben sich aus den Patentansprüchen, der Beschreibung und den Zeichnungen. Die in der Beschreibungseinleitung genannten Vorteile von Merkmalen und von Kombinationen mehrerer Merkmale sind lediglich beispielhaft und können alternativ oder kumulativ zur Wirkung kommen, ohne dass die Vorteile zwingend von erfindungsgemäßen Ausführungsformen erzielt werden müssen. Weitere Merkmale sind den Zeichnungen - insbesondere den dargestellten Geometrien und den relativen Abmessungen mehrerer Bauteile zueinander sowie deren relativer Anordnung und Wirkverbindung - zu entnehmen. Die Kombination von Merkmalen unterschiedlicher Ausführungsformen der Erfindung oder von Merkmalen unterschiedlicher Patentansprüche ist ebenfalls abweichend von den gewählten Rückbeziehungen der Patentansprüche möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Patentansprüche kombiniert werden. Ebenso können in den Patentansprüchen aufgeführte Merkmale für weitere Ausführungsformen der Erfindung entfallen.

### KURZBESCHREIBUNG DER FIGUREN

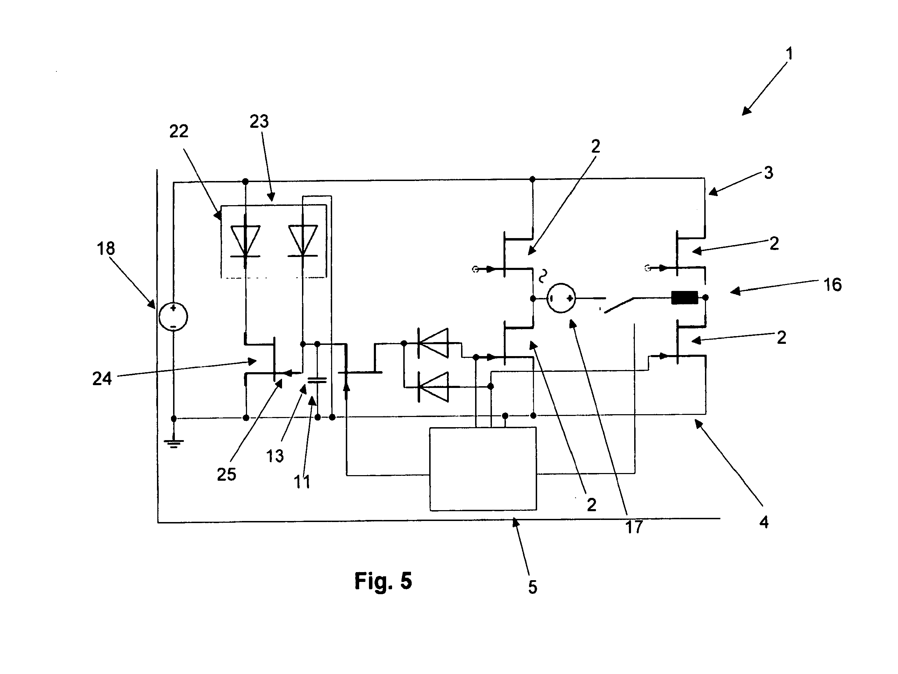

Die Erfindung wird im Folgenden unter Bezugnahme auf die beigefügten Figuren anhand von Ausführungsbeispielen näher erläutert und beschrieben, wobei nur Fig. 5 eine erfindungsgemäße Schaltung zeigt.
- **Fig. 1**: skizziert eine erste Ausführungsform einer Schaltung mit einem selbstleitenden Halbleiterschalter zwischen zwei Eingangsleitungen und einer zusätzlichen, eine Batterie aufweisenden Spannungsquelle.
- **Fig. 2**: skizziert eine Abwandlung der Schaltung gemäß Fig. 1, wobei die zusätzliche Gleichspannungsquelle einen Kondensator als Speicher für elektrische Ladung aufweist.
- **Fig.3**: zeigt eine Ausführungsform einer elektrischen Schaltung mit einer Wechsel- richterbrücke zwischen den Eingangsleitungen, wobei die zusätzliche Gleichspannungsquelle wieder einen Kondensator als Speicher für elektrische Ladung aufweist.
- **Fig.4**: zeigt eine Abwandlung der Schaltung gemäß Fig. 3 mit einer Batterie als Speicher für elektrische Ladung.
- **Fig. 5**: zeigt eine erfindungsgemäße Abwandlung der Schaltung gemäß Fig. 3 mit einem über einen photovoltaischen MOSFET-Treiber aufgeladenen Kondensator als Speicher für elektrische Ladung.
- **Fig. 6**: zeigt eine Abwandlung der elektrischen Schaltung gemäß Fig. 3 mit einer über einen Wechselspannungsabgriffspunkt der Wechselrichterbrücke gespeisten Gleichspannungsquelle.

### FIGURENBESCHREIBUNG

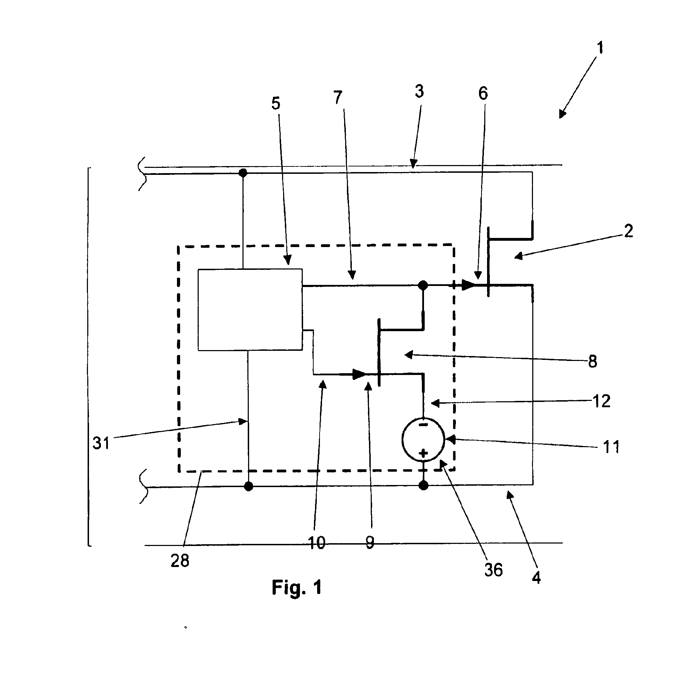

Die in **Fig. 1** skizzierte elektrische Schaltung 1 weist einen selbstleitenden Halbleiterschalter 2 zwischen zwei Eingangsleitungen 3 und 4 auf. Da der Halbleiterschalter 2 hier das einzige Bauteil ist, das zwischen die Eingangsleitungen 3 und 4 geschaltet ist, ist die Schaltung 1 zwischen den Eingangsleitungen 3 und 4 ohne Ansteuerung des Halbleiterschalters 2 ihrerseits selbstleitend. Eine Steuerung 5 steuert den Steueranschluss 6 des Halbleiterschalters 2 mit Steuerspannungen 7 an, um den Halbleiterschalter 2 im Betrieb der Schaltung 1 zu takten. Um bei Ausfall der Steuerung 5 einen Kurzschluss zwischen den Eingangsleitungen 3 und 4 zu verhindern, ist eine Gleichspannungsquelle 11 vorgesehen, die ein Sperrpotential 12 an den Steueranschluss 6 anlegt. Als Speicher für elektrische Ladung weist die Gleichspannungsquelle hier eine auswechselbare Batterie 36 auf. Damit das Sperrpotential 12 die Steuerspannungen 7 nicht stört, ist in der Leitung zwischen der Gleichspannungsquelle 11 und dem Steueranschluss 6 ein weiterer selbstleitender Halbleiterschalter 8 vorgesehen, dessen Steueranschluss 9 im Betrieb der Schaltung 1 von der Steuerung 5 mit einem Sperrpotential 10 beaufschlagt wird, so dass er sperrt. Bei Ausfall der Steuerung 5 entfällt das Sperrpotential 10, und das Sperrpotential 12 von der Gleichspannungsquelle 11 liegt an dem Steueranschluss 6 des Halbleiterschalters 2 an und sperrt diesen. Über eine Leitung 31 wird der Steuerung ein Bezugspotential von der Eingangsleitung 4 zugeführt. Mit einer gestrichelten Linie ist in Fig. 1 eine Teilschaltung 28 umrandet, die eine Gatebeschaltung des Steueranschlusses 6 des Halbleiterschalters 1 ausbildet.

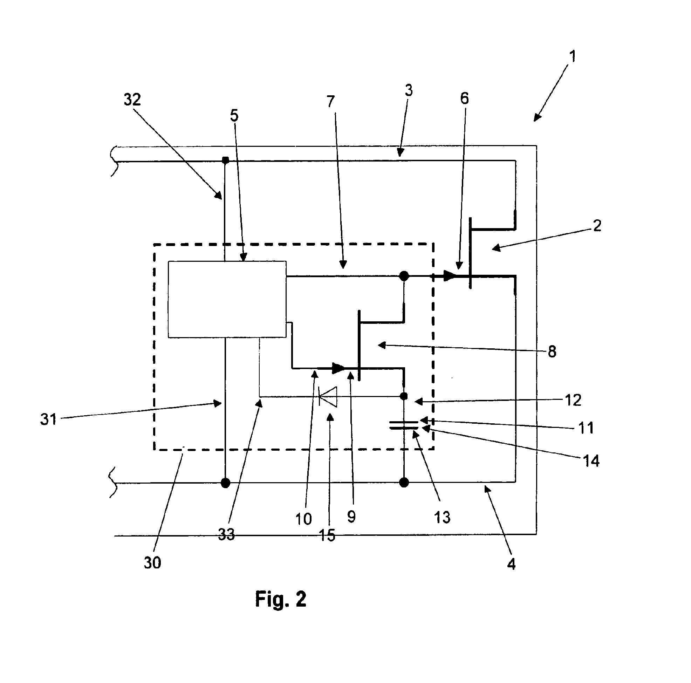

Die Schaltung 1 gemäß **Fig. 2** unterscheidet sich von derjenigen gemäß Fig. 1 dadurch, dass die Gleichspannungsquelle 11 hier einen Kondensator 13 als Speicher 14 für elektrische Ladung aufweist. Der Kondensator 14 wird von der Steuerung 5 über eine Leitung 32 aus einer zwischen den Eingangsleitungen 3 und 4 anliegenden und mit Leitungen 31 und 32 abgegriffenen Spannung aufgeladen. Dabei wird die Ladung durch eine Sperrdiode 15 auch bei einem Abfall der Steuerung 5 auf dem Kondensator 14 gehalten, so dass eine Gleichspannung für das Anlegen des Sperrpotentials 12 an den Steueranschluss 6 des Halbleiterschalters 2 bereitsteht. Mit einer gestrichelten Linie ist in Fig. 2 eine Teilschaltung 30 umrandet, die eine Gatebeschaltung des Steueranschlusses 6 des Halbleiterschalters 1 ausbildet.

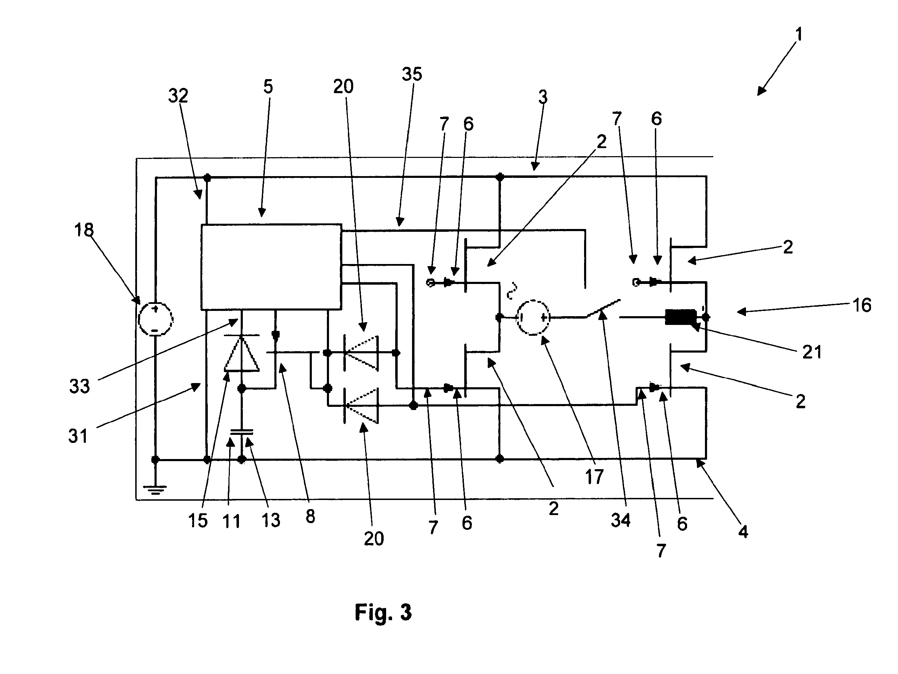

**Fig. 3** zeigt eine Schaltung 1, die zwischen den Eingangsleitungen 3 und 4 eine Wechselrichterbrücke 16 mit hier insgesamt 4 selbstleitenden Halbleiterschaltern 2 aufweist. Dabei sind die Leitungen, über die die Steuerung die Halbleiterschalter 2 im Betrieb der Schaltung 1 taktet nicht wiedergegeben. Die beiden parallel zwischen den Eingangsleitungen 3 und 4 verlaufenden Zweige der Wechselrichterbrücke 16 umfassen jeweils zwei Halbleiterschalter 2, zwischen denen einer von zwei Polen eines Wechselspannungsabgriffpunkts 17 gebildet ist. Dabei ist der Wechselspannungsabgriffpunkt 17 mit einer Induktivität 21 zwischen den Zweigen der Wechselrichterbrücke 16 in Reihe geschaltet. Der so ausgebildete Wechselrichter für eine an den Eingangsleitungen 3 und 4 anliegende Gleichspannung einer externen Spannungsquelle 18 kann zusätzlich einen hier nicht dargestellten, parallel zu der Wechselrichterbrücke 16 zwischen die Eingangsleitung 3 und 4 geschalteten Pufferkondensator 19 aufweisen. Ein solcher Pufferkondensator ist dann typischerweise deutlich größer dimensioniert, d. h. er weist eine wesentlich größere Kapazität auf als der Kondensator 13, mit dem nur die kleinen Ladungen bereitgestellt werden müssen, um beim Ausfall der hier nicht dargestellten Steuerung die Wechselrichterbrücke 16 zu sperren. Dabei erfolgt die Sperrung hier nur über die beiden unteren Halbleiterschalter 2 der Wechselrichterbrücke 16, die in den von der Eingangsleitung 4 abgehenden Leitungen der Wechselrichterbrücke 16 vorgesehen sind. Wenn diese beiden unteren Halbleiterschalter sperren, kann zwischen den Eingangsleitungen 3 und 4 kein Strom mehr über die Wechselrichterbrücke 16 fließen und insbesondere können sich die Ladungen auf den Pufferkondensator 19 nicht in unkontrollierter Weise über die Wechselrichterbrücke 16 ausgleichen und dabei einen den Bestand der Wechselrichterbrücke 16 gefährdenden Strom hervorrufen. In den Leitungen zwischen dem Schalter 8 und den Steueranschlüssen 6 der Halbleiterschalter 2 vorgesehene Sperrdioden 20 entkoppeln die Steueranschlüsse 6, um die Ansteuerung dieser Steueranschlüsse 6 über die Steuerspannungen 7 nicht wechselseitig zu stören. Über eine Leitung 35 steuert die Steuerung ein Netzrelais 34 zum Zuschalten der Gleichspannungsquelle 18 zu einem an den Wechselspannungsabgriffspunkt 17 angeschlossenen Wechselstromnetz an.

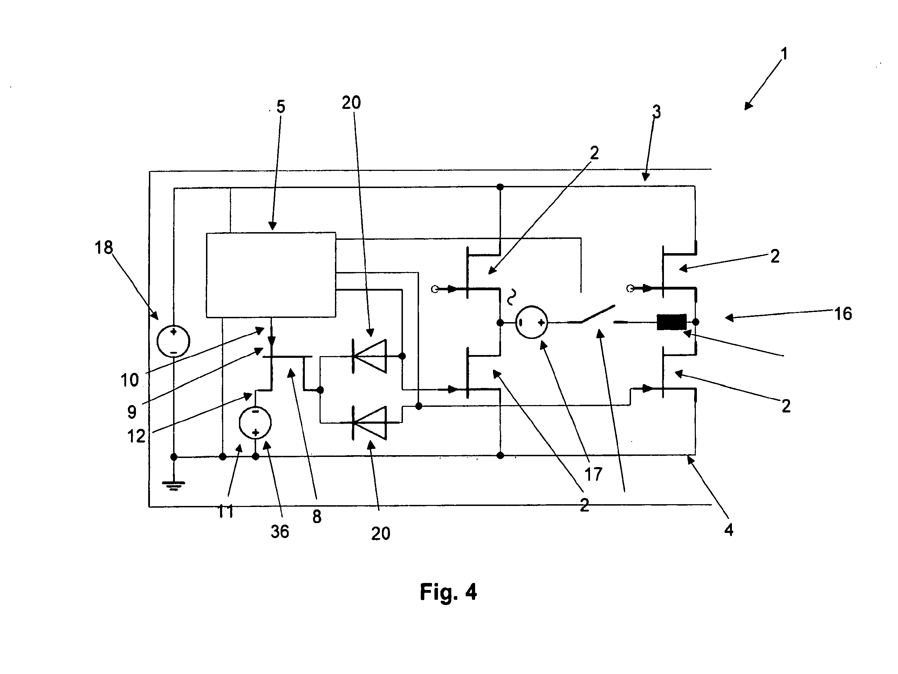

Die in Fig. 3 gezeigte Schaltung vermag zwar einen unkontrollierten Kurzschluss bei Ausfall der Steuerung zwischen den Eingangsleitungen 3 und 4 zu vermeiden. Sie erlaubt aber weder einen anfänglichen Spannungsaufbau zwischen den Eingangsleitungen 3 und 4, solange die Steuerung noch nicht aktiv ist, noch verhindert sie einen Kurzschluss einer an dem Wechselspannungsabgriffspunkt 17 anliegenden Spannung über die Wechselrichterbrücke 16. Diese Unzulänglichkeiten weist die Schaltung 1 gemäß **Fig. 4** nicht auf. Hier wird das Sperrpotential 12 von der wieder mit einer Batterie 36 als Speicher für elektrische Ladung ausgebildeten Gleichspannungsquelle 11 bei Ausfall der Steuerung an alle vier Halbleiterschalter 2 der Wechselrichterbrücke 16 angelegt, und diese Sperrpotentiale stehen auch zu Beginn, d h. vor dem Anlaufen der Steuerung zur Verfügung, so dass sich eine Spannung zwischen den Eingangsleitungen 3 und 4 zu Anfang aufbauen kann, mit der dann beispielsweise auch die Steuerung der Schaltung versorgt werden kann. Dies ist insbesondere dann von Vorteil, wenn die externe Gleichspannungsquelle 18 eine Photovoltaikanlage ist, deren Ausgangsspannung am Morgen bei null beginnt.

Bei der Schaltung 1 gemäß **Fig. 5** ist die Gleichspannungsquelle 11 mit einer Ladeschaltung 23 kombiniert, die auf einem photovoltaischen MOSFET-Treiber 22 basiert. Die Ladeschaltung 23 ist in Reihe mit einem weiteren selbstleitenden Halbleiterschalter 24 zwischen die Eingangsleitungen 3 und 4 geschaltet. Der Steueranschluss 25 des Halbleiterschalters 24 wird durch die Ausgangsspannung der Gleichspannungsquelle 11 als Sperrpotential beaufschlagt. D. h., durch den Halbleiterschalter 24 fließt nur dann Strom, wenn die Ausgangsspannung der Gleichspannungsquelle 11 niedrig ist. Dann ruft der durch die Ladeschaltung 23 eingangsseitig fließende Strom einen ausgangsseitigen Strom hervor, der die Gleichspannungsquelle 11 bzw. deren Speicher für elektrische Ladung auflädt, bis ihre Ausgangsspannung den selbstleitenden Halbleiterschalter sperrt. Dabei kann der Speicher für elektrische Ladung der Gleichspannungsquelle 11 beispielsweise ein Kondensator 13 kleiner Kapazität sein, der auch dann durch einen eingangsseitigen Strom durch die Ladeschaltung 23 aufgeladen wird, wenn die Wechselrichterbrücke 16 noch selbstleitend ist, weil der Innenwiderstand der Ladeschaltung 23 in der Reihenschaltung mit dem selbstleitenden Halbleiterschalter 24 von derselben Größenordnung ist, wie derjenige der selbstleitenden Wechselrichterbrücke 16. So kann beispielsweise der Ausgangsstrom einer Photovoltaikanlage als externe Spannungsquelle 18 zunächst die Gleichspannungsquelle 11 aufladen, wobei zwischen den Eingangsleitungen 3 und 4 nur eine kleine ungefährliche Spannung anliegt. Dann werden alle selbstleitenden Halbleiterschalter 2 und 24 gesperrt, und die Arbeitsausgangsspannung der Photovoltaikanlage 18 kann sich aufbauen.

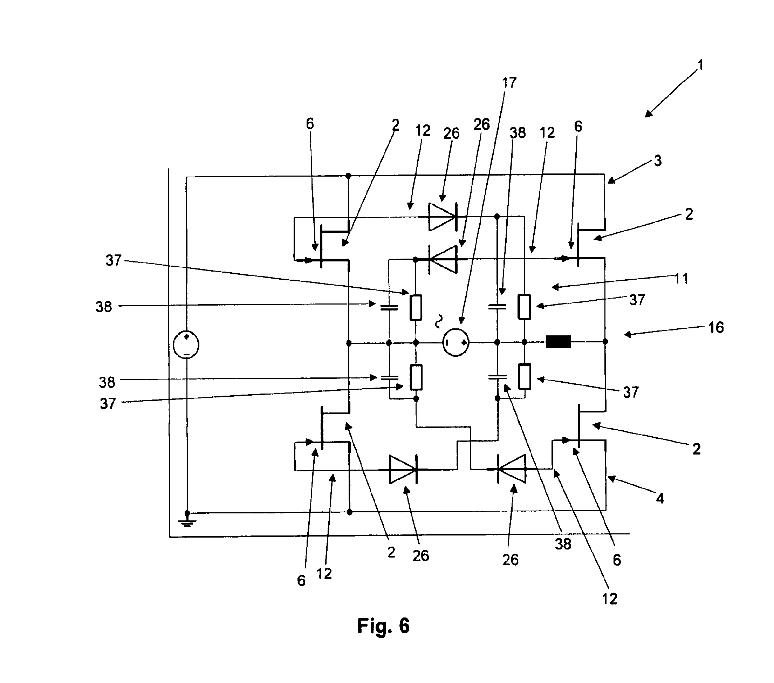

Während bei den Ausführungsformen der Schaltung 1 als Wechselrichter gemäß den Fig. 3 und 5 die Gleichspannungsquelle 11 zur Bereitstellung der Sperrpotentiale über die Eingangsleitungen 3 und 4 gespeist wurde, wird sie bei der Ausführungsform gemäß **Fig. 6** über den Wechselspannungsabgriffspunkt 17 gespeist, d. h. von einer hier anliegenden externen Wechselspannung, beispielsweise derjenigen eines Wechselstromnetzes, in das mit der Schaltung 1 Strom aus einer Photovoltaikanlage eingespeist wird. Hierzu wird die an dem Wechselspannungsabgriffspunkt 17 anliegende Wechselspannung mit Gleichrichterdioden 26 gleichgerichtet, um die Sperrpotentiale 12 bereitzustellen. Widerstände 37 und Kondensatoren 38 dienen dabei zur Begrenzung des zu den Steueranschlüssen 6 der Halbleiterschalter 2 fließenden Stroms bzw. der Spannung der Sperrpotentiale. Ein Speicher für elektrische Ladung ist bei der Schaltung 1 gemäß Fig. 6 nicht vorgesehen. Vielmehr ist die Gleichspannungsquelle 11, soweit sie nur die in Fig. 6 gezeigten Bestandteile aufweist, darauf angewiesen, dass eine externe Wechselspannung an dem Wechselspannungsabgriffspunkt 17 anliegt. Als weitere Abweichung gegenüber von Fig. 3 sind auch hier wie in den Fig. 4 und 5 alle vier Halbleiterschalter 2 der Wechselrichterbrücke 16 über Sperrpotentialleitungen mit der Gleichspannungsquelle 11 verbunden, um bei Ausfall der Steuerung auch einen Kurzschluss zwischen den Polen des Wechselspannungsabgriffpunkts 17 über die Wechselrichterbrücke 16 zu vermeiden.

## Patentansprüche

1. Elektrische Schaltung zwischen zwei Eingangsleitungen (3, 4), zwischen denen im Betrieb der Schaltung (1) eine Eingangsspannung fester Polarität anliegt,
- mit einer Wechselrichterbrücke (16) zwischen den Eingangsleitungen (3, 4), die zwei Halbleiterschalter (2) je Zweig aufweist, die ohne Ansteuerung ihres Steueranschlusses selbstleitend sind, so dass die Wechselrichterbrücke (16) zwischen den Eingangsleitungen (3, 4) selbstleitend ist,
- mit einer Steuerung (5), die die Halbleiterschalter der Wechselrichterbrücke (16) im Betrieb der Schaltung (1) taktet, indem sie die Steueranschlüsse (6) der selbstleitenden Halbleiterschalter (2) mit Steuerspannungen (7) ansteuert, und
- mit einer Gleichspannungsquelle (11), die bei Ausfall der Steuerung (5) ein Sperrpotential (12) an die Steueranschlüsse (6) mindestens einer Teilmenge der selbstleitenden Halbleiterschalter (2) der Wechselrichterbrücke (16) anlegt, wobei die Halbleiterschalter (2) der Teilmenge so ausgewählt sind, dass sie die Wechselrichterbrücke (16) sperren, wenn sie selbst durch Ansteuerung ihrer Steueranschlüsse (6) gesperrt sind, um einen Kurzschluss zwischen den Eingangsleitungen (3, 4) zu verhindern,
- wobei die Gleichspannungsquelle (11) einen Speicher (14) für elektrische Ladung mit einem Akkumulator oder Kondensator (13) aufweist,
**dadurch gekennzeichnet, dass** die Gleichspannungsquelle (11) eine zwischen die Eingangsleitungen (3, 4) mit einem weiteren selbstleitenden Halbleiterschalter (24) in Reihe geschaltete Ladeschaltung (23) aufweist, bei der ein eingangsseitig fließender Strom einen ausgangsseitigen Strom hervorruft, der den Speicher (14) für elektrische Ladung auflädt, wobei die als Sperrpotential dienende Spannung des Speichers (14) auch an dem Steueranschluss (25) des weiteren selbstleitenden Halbleiterschalters (24) anliegt.

2. Schaltung nach Anspruch 1, **dadurch gekennzeichnet, dass** die Gleichspannungsquelle (11) kein in Reihe mit den Halbleiterschaltern (2) der Wechselrichterbrücke (16) zwischen die Eingangsleitungen (3, 4) geschaltetes Bauteil aufweist.

3. Schaltung nach Anspruch 1 oder 2, **dadurch gekennzeichnet, dass** die Gleichspannungsquelle (11) kein parallel zu der Wechselrichterbrücke (16) zwischen die Eingangsleitungen (3, 4) geschaltetes Bauteil aufweist, über das während des Betriebs der Schaltung (1) andauernd Strom fließt.

4. Schaltung nach einem der Ansprüche 1 bis 3, **dadurch gekennzeichnet, dass** zwischen der Gleichspannungsquelle (11) und den Steueranschlüssen (6) der selbstleitenden Halbleiterschalter (2) der Wechselrichterbrücke (16) ein ansteuerbares Schaltelement, insbesondere ein selbstleitender Halbleiterschalter (8), angeordnet ist, dessen Steueranschluss durch die Steuerung (5) im Betrieb der Schaltung (1) angesteuert wird.

5. Schaltung nach einem der Ansprüche 1 bis 4, **dadurch gekennzeichnet, dass** zwischen den beiden Eingangsleitungen (3, 4) im Betrieb der Schaltung (1) eine Gleichspannung anliegt.

6. Schaltung nach einem der Ansprüche 1 bis 5, **dadurch gekennzeichnet, dass** die Gleichspannungsquelle (11) bei Ausfall der Steuerung (5) das Sperrpotential (12) an die Steueranschlüsse (6) von je einem selbstleitenden Halbleiterschalter (2) je Zweig der Wechselrichterbrücke (16) anlegt, wobei diese Halbleiterschalter (2) alle in von einer der Eingangsleitungen (3 oder 4) abgehenden Leitungen der Wechselrichterbrücke (16) angeordnet sind.

7. Verwendung einer Schaltung nach einem der Ansprüche 1 bis 6 als Wechselrichter zur Einspeisung von elektrischer Energie von einer externen Gleichspannungsquelle (18), insbesondere von einer Photovoltaikanlage, in ein Wechselstromnetz.

## Claims

1. An electric circuit (1) between two input lines (3, 4) between which a voltage of a fixed polarity is applied in operation of the circuit (1);
- having an inverter bridge (16) between the input lines (3, 4) which comprises two semiconductor switches (2) per half bridge which are normally conductive without controlling their gate such that the inverter bridge (16) is normally conductive between the input lines, (3, 4);
- having a controller (5) which clocks the semiconductor switches of the inverter bridge (16) in operation of the circuit (1) in that it controls the gates (6) of the normally conductive semiconductor switches (2) with control voltages (7); and
- comprising a DC voltage source (11) which, upon failure of the controller (5), applies a blocking voltage (12) to the gates (6) of at least some of the normally conductive semiconductor switches (2) of the inverter bridge (16), the at least some of the semiconductor switches (2) being selected in such a way that they make the inverter bridge (16) non-conductive, if they are made non-conductive by means of controlling their gates (6), to the end of avoiding a short-circuit between the input lines (3, 4);
- the DC voltage source (11) comprising a storage (14) for electric charge having an accumulator or capacitor (13);
**characterized in that** the DC voltage source (11) comprises a charging unit (23) connected between the input lines (3, 4) in series with a further normally conductive semiconductor switch (24), in which a current flowing through an input side causes a current through an output side which charges the storage (14) for electric charge; wherein the voltage across the storage (14) serving as the blocking voltage is also present at the gate (25) of the further normally conductive semiconductor switch (24).

2. The circuit of claim 1, **characterized in that** the DC voltage source (11) comprises no element connected between the input lines (3, 4) in series with the semiconductor switches (2) of the inverter bridge (16).

3. The circuit of claim 1 or 2, **characterized in that** the DC voltage source (11) comprises no element connected between the input lines (3, 4) in parallel to the inverter bridge (16), through which a continuous current flows in operation of the circuit.

4. The circuit of any of the claims 1 to 3, **characterized in that** a controllable switching element, particularly a normally conductive semiconductor switch (8) is connected between the DC voltage source (11) and the gates (6) of the normally conductive semiconductor switches (2) of the inverter bridge (16), whose gate is controlled by the controller (5) in operation of the circuit (1).

5. The circuit of any of the claims 1 to 4, **characterized in that** a DC voltage is applied between the input lines (3, 4) in operation of the circuit (1).

6. The circuit of any of the claims 1 to 5, **characterized in that** the DC voltage source (11), upon failure of the controller (5), applies the blocking voltage (12) to the gates (6) of one normally conductive semiconductor switch (2) per half bridge of the inverter bridge (16), all of these normally conductive semiconductor switches (2) being arranged in lines of the inverter bridge (16) which are connected to the same one of the two input lines (3, 4).

7. A use of a circuit of any of the claims 1 to 6 as an inverter for feeding electric power from an external DC Voltage source (18), particularly from a photovoltaic generator, into an AC power grid.

## Revendications

1. Circuit électrique entre deux lignes d'entrée (3, 4) entre lesquelles une tension d'entrée de polarité fixe est appliquée en cours de fonctionnement du circuit (1),
- avec un pont onduleur (16) entre les lignes d'entrée (3, 4), présentant deux commutateurs semi-conducteurs (2) par branche qui sont normalement conducteurs sans excitation de leur gâchette, de sorte que le pont onduleur (16) est normalement conducteur entre les lignes d'entrée (3, 4),
- avec une commande (5) qui synchronise les commutateurs semi-conducteurs du pont onduleur (16) en cours de fonctionnement du circuit (1) en excitant les gâchettes (6) des commutateurs semi-conducteurs (2) normalement conducteurs par des tensions de commande (7), et
- avec une source de tension continue (11) qui applique en cas de défaillance de la commande (5) un potentiel de blocage (12) aux gâchettes (6) au moins d'un sous-ensemble des commutateurs semi-conducteurs (2) normalement conducteurs du pont onduleur (16), dans lequel les commutateurs semi-conducteurs (2) du sous-ensemble sont sélectionnés de telle sorte qu'ils bloquent le pont onduleur (16) lorsqu'ils sont eux-mêmes bloqués par l'excitation de leurs gâchettes (6) afin d'empêcher un court-circuit entre les lignes d'entrée (3, 4),
- dans lequel la source de tension continue (11) présente une unité de stockage (14) pour une charge électrique avec un accumulateur ou condensateur (13),
**caractérisé en ce que** la source de tension continue (11) présente un circuit de charge (23) connecté en série entre les lignes d'entrée (3, 4) avec un autre commutateur semi-conducteur (24) normalement conducteur, dans lequel un courant circulant côté entrée provoque un courant côté sortie qui charge l'unité de stockage (14) pour une charge électrique, la tension de l'unité de stockage (14) servant de potentiel de blocage étant également appliquée à la gâchette (25) du commutateur semi-conducteur (24) normalement conducteur supplémentaire.

2. Circuit selon la revendication 1, **caractérisé en ce que** la source de tension continue (11) ne présente aucun composant connecté en série avec les commutateurs semi-conducteurs (2) du pont onduleur (16) entre les lignes d'entrée (3, 4).

3. Circuit selon la revendication 1 ou 2, **caractérisé en ce que** la source de tension continue (11) ne présente aucun composant connecté en parallèle au pont onduleur (16) entre les lignes d'entrée (3, 4), par lequel un courant passerait en continu pendant le fonctionnement du circuit (1).

4. Circuit selon l'une quelconque des revendications 1 à 3, **caractérisé en ce qu'**entre la source de tension continue (11) et les gâchettes (6) des commutateurs semi-conducteurs (2) normalement conducteurs du pont onduleur (16) est disposé un élément de commutation à exciter, en particulier un commutateur semi-conducteur (8) normalement conducteur, dont la gâchette est excitée par la commande (5) en cours de fonctionnement du circuit (1).

5. Circuit selon l'une quelconque des revendications 1 à 4, **caractérisé en ce qu'**entre les deux lignes d'entrée (3, 4) une tension continue est appliquée en cours de fonctionnement du circuit (1).

6. Circuit selon l'une quelconque des revendications 1 à 5, **caractérisé en ce que** la source de tension continue (11), en cas de défaillance de la commande (5), applique le potentiel de blocage (12) aux gâchettes (6) respectivement d'un commutateur semi-conducteur (2) normalement conducteur de chaque branche du pont onduleur (16), dans lequel ces commutateurs semi-conducteurs (2) sont tous disposés sur des lignes du pont onduleur (16) dérivant d'une des lignes d'entrée (3 ou 4).

7. Utilisation d'un circuit selon l'une quelconque des revendications 1 à 6 en tant que pont onduleur pour injecter de l'énergie électrique provenant d'une source de tension continue (18) externe, en particulier d'une installation photovoltaïque, dans un réseau de courant alternatif.
